# EUROPÄISCHE PATENTSCHRIFT

(11) **EP 0 840 940 B1**
(45) Veröffentlichungstag und Bekanntmachung des Hinweises auf die Patenterteilung: **14.06.2000**
(21) Anmeldenummer: 96930950.9
(22) Anmeldetag: 24.07.1996
(51) Int. Cl.: H01J 37/26, H01J 37/305, H01J 37/30, G01N 1/32

(54) **VERFAHREN UND VORRICHTUNG ZUR IONENDÜNNUNG IN EINEM HOCHAUFLÖSENDEN TRANSMISSIONSELEKTRONENMIKROSKOP**
PROCESS AND DEVICE FOR ION THINNING IN A HIGH-RESOLUTION TRANSMISSION ELECTRON MICROSCOPE
PROCEDE ET DISPOSITIF POUR L'AMINCISSEMENT IONIQUE DANS UN MICROSCOPE ELECTRONIQUE A TRANSMISSION HAUTE RESOLUTION

(30) Priorität: 25.07.1995 DE 19527059
(43) Veröffentlichungstag der Anmeldung: 13.05.1998
(73) Patentinhaber: NMI NATURWISSENSCHAFTLICHES UND MEDIZINISCHES INTITUT AN DER UNIVERSITÄT TÜBINGEN IN REUTLINGEN, 72770 Reutlingen (DE)
(72) Erfinder: NISCH, Wilfried, D-72072 Tübingen (DE); GNAUCK, Peter, D-72764 Reutlingen (DE)
(74) Vertreter: Jany, Peter
(86) Internationale Anmeldenummer: DE9601408
(87) Internationale Veröffentlichungsnummer: WO9705644

(56) Entgegenhaltungen:
- DE-U- 29 507 225
- PATENT ABSTRACTS OF JAPAN vol. 95, no. 004 & JP,A,07 092062 (NATL RES INST FOR METALS), 7.April 1995
- PATENT ABSTRACTS OF JAPAN vol. 018, no. 595 (E-1630), 14.November 1994 & JP,A,06 231719 (SEIKO INSTR INC), 19.August 1994

## Beschreibung

Die Erfindung betrifft ein Verfahren und eine entsprechende Vorrichtung zur Ionendünnung einer Probe im Probenraum eines Transmissionselektronenmikroskops, das eine Objektivlinse aufweist, wobei eine Ionenquelle zur Erzeugung eines Ionenstrahls, eine Ionenlinse, ein Sekundärelektronendetektor zur Erzeugung eines Ionenraster-Sekundärelektronenbildes der Probenoberfläche mit Hilfe der bei gerasteter Ionenbestrahlung ausgelösten Sekundärelektronen und zur Positionierung des Ionenstrahls mittels des Ionenraster-Sekundärelektronenbildes auf eine bestimmte Probenstelle vorgesehen sind.

Zur Probenpräparation für die hochauflösende Transmissionselektronenmikroskopie werden die Proben in bekannter Weise mittels mechanischer oder chemischer Verfahren auf eine Ausgangsdicke von ca. 10 µm vorgedünnt. Anschließend werden die Proben durch Beschuß mit einem Ionenstrahl unter einem möglichst flachen Winkel zur Probenoberfläche ionengedünnt, bis in der Probenmitte ein kleines Loch von ca. 100-200 µm Durchmesser entsteht. Im Randbereich des Lochs ist die Probe dann in einem keilförmigen Bereich genügend dünn und für schnelle Elektronen von mehr als 100 keV transparent.

Für die hochauflösende Transmissionselektronenmikroskopie, die dadurch gekennzeichnet ist, daß der Anteil der inelastischen Streuung der Elektronen in der Probe gering ist, müssen die Proben genügend dünn sein. Ab einer Dicke von etwa 100 nm ist eine hohe laterale Auflösung von etwa 1,5 nm, entsprechend einer elektronenmikroskopischen Vergrößerung von 100.000, erzielbar. Für die höchstauflösende Transmissionselektronenmikroskopie, bei der laterale Auflösungen bis 0,15 nm, entsprechend Vergrößerungsfaktoren von 1 Million, erzielt werden, muß die Probe auf eine Dicke von weniger als 10 nm gedünnt werden. Neben der hochauflösenden Elektronenmikroskopie werden sehr dünne Objektstellen, die frei von Reaktionsschichten, Kontaminationsschichten und durch die Ionendünnung geschädigten amorphisierten Schichten sind, auch in der Elektronenholographie benötigt.

Die üblicherweise bei der Probenpräparation für die Transmissionselektronenmikroskopie eingesetzten Ionendünnungsverfahren arbeiten im wesentlichen "blind", d.h. es bleibt weitgehend dem Zufall überlassen, ob ein interessantes Objektdetail in guter Qualität herauspräpariert wurde. Im Stand der Technik sind daher Einrichtungen vorgeschlagen worden, mit denen eine Probe im Transmissionselektronenmikroskop-Probenhalter in einer externer Ätzeinrichtung unter gleichzeitiger Beobachtung gedünnt werden kann.

In der Literaturstelle Gatan Inc., 6678 Owens Drive, Pleasanton, CA 94566 USA, Produktspezifikation "Precision ion milling system" (PIMS), Modell 645, Juni 1987, wurde vorgeschlagen, hierfür eine Abbildung der ausgelösten Sekundärelektronen zu verwenden. In den Literaturstellen H. Bach, Bosch Technische Berichte 1, 1964, 10-13 und F. Nagata et al., Proc. 41 st. confer. JSEM. 1985, 133, wurde vorgeschlagen, die Probe zur Ionendünnung in der Zwischenbildebene eines Transmissionselektronenmikroskops in Transmission zu beoachten.

Nachteilig bei diesen bekannten Ätzeinrichtungen ist, daß die erzielbare Auflösung für die Beurteilung der Probenqualität unzureichend ist und daß nach erfolgter Ionendünnung die Probe mit dem Probenhalter zur hochauflösenden Beobachtung der Probe in das Feld der Objektivlinse gebracht werden muß. Dabei reagiert die dünne Probe mit der Luft und mit dem Restgas unter Bildung störender Reaktions- und Kontaminationsschichten.

Weiterhin ist nachteilig, daß zumeist ein mehrfacher Wechsel zwischen hochauflösender Beobachtung und weiterer Dünnung erforderlich ist, um die gewünschte Schichtdicke zu erzielen. Dabei stellt sich nicht nur das Problem, die Objektstelle bei einer erneuten Beobachtung wieder aufzufinden, was bei hoher lateraler Auflösung äußerst problematisch sein kann, sondern durch die hochauflösende transmissionselektronenmikroskopische Beobachtung bilden sich aufgrund der hochenergetischen Elektronenbestrahlung störende Kontaminationsschichten, insbesondere aus Kohlenwasserstoffen, so daß es auch aus diesem Grund erforderlich sein kann, eine neue Probenstelle zu präparieren, wozu eine erneute Dünnung an einer anderen Stelle erforderlich ist.

Ein weiteres, sich bei der hochauflösenden Transmissionselektronenmikroskopie stellendes Problem ergibt sich dadurch, daß die Objektivlinse nicht beliebig ein- und ausgeschaltet werden kann. Die Objektivlinse erzeugt das für die hohe Auflösung erforderliche magnetische Feld am Ort der Probe von ca. 1 bis 2 T und bewirkt eine Festvergrößerung von 100 bis 200. Beim Einschalten der Objektivlinse treten aufgrund verschiedener Einflüsse wie der Stromstabilität, Wärmeausdehnungs- und Wärmeausgleichseffekten und anderer Ursachen Driften auf, die bis zum Erreichen eines für eine Beoabachtung erforderlichen stabilen Betriebs erst nach einer Zeitdauer von zwei Stunden oder länger abklingen. Es ist daher nicht möglich, zwischen hochauflösender Beobachtung mit eingeschalteter Objektivlinse bei ca. 1.000.000-facher Vergrößerung und niedriger, langbrennweitiger Vergrößerung mit ausgeschalteter Objektivlinse, gegebenenfalls unter Zuschaltung einer Mini- oder Zwischenlinse, die kein Magnetfeld in der Objektebene erzeugt, bei bis ca. 10.000-facher Vergrößerung kurzfristig umzuschalten. Andererseits ist es aufgrund der sehr beengten Platzverhältnisse, insbesondere im Bereich der Objektivlinse, nicht möglich, eine Probe im Vakuum des Transmissionselektronenmikroskops aus der Zwischenbildlage in die Objektivebene zu verfahren; hierzu muß die Probe ausgeschleust werden.

In dem Dokument DE 29507225 U1 wurde eine Ionenstrahlpräparationsvorrichtung für die Elektronenmikroskopie vorgeschlagen, mittels der eine Ionendünnung unter gleichzeitiger elektronenmikroskopischer Beobachtung durchführbar ist. Eine hochauflösende Beobachtung ist mit der dort vorgeschlagenen Anordnung jedoch nicht möglich, da am Ort der Probe mangels einer dort angeordneten Objektivlinse kein Magnetfeld vorhanden ist und die Elektronenenergie gering ist. Die Probe ist nicht im Probenraum der Objektivlinse eines Transmissionselektronenmikroskops angeordnet.

In der Druckschrift JP-(A) 6-231719 wurde eine Präparationsmethode zum Präparieren von Schnitten in Halbleitern vorgeschlagen, bei der eine mit einer Passivierungsschutzschicht versehene Probenstelle von ca. 100 nm Dicke mittels einer fast-ion-beam-Ionenquelle von 30 keV in der Objektivebene der Objektivlinse eines Transmissionselektronenmikroskops gedünnt wird. Aufgrund der hohen Energie der Ionen, die Probleme hinsichtlich des Arbeitsabstands erheblich reduziert, werden Strahlenschäden verursacht, und der große Materialabtrag führt zu Ablagerungen auf den Linsen und somit zu Abbildungsfehlern. Auch ist es mit der in dieser Druckschrift vorgeschlagenen Apparatur nicht möglich, unter hochauflösenden Bedingungen, d.h. bei Vergrößerungen über 10.000 oder 100.000, die Probe zu dünnen, da bei eingeschalteter Objektivlinse der Ionenstrahl nicht auf die Probe trifft. Es wird daher in der Druckschrift vorgeschlagen, zwischen Ionendünnung und hoher Auflösung hin und her zu schalten, was mit den obengenannten Nachteilen verbunden ist.

In der Druckschrift JP-A-7092062 ist eine Ionenätzeinrichtung für ein Transmissionselektronenmikroskop beschrieben, bei dem die Ionenquelle gegenüber der Objektivebene um 55° verkippt ist und eine Ionenenergie von 25 KeV verwendet wird.

Es wurde von der Fachwelt für erforderlich gehalten, die Ionendünnung bei ausgeschalteter Objektivlinse durchzuführen, damit der Ionenstrahl auf die Probenstelle trifft. Die damit verbundenen Nachteile wurden bislang in Kauf genommen.

Der Erfindung liegt unter Berücksichtigung dieses Standes der Technik die Aufgabe zugrunde, die Probenpräparationstechnik für die Transmissionselektronenmikroskopie derart zu verbessern, daß die Probe unter gleichzeitiger Transmissionselektronenmikroskopischer, hochauflösender Beobachtung in der Objektivebene des Transmissionselektronenmikroskops "in situ" gedünnt werden kann, um eine Wiederbildung von Reaktionsschichten an Luft zu vermeiden und die Experimentierzeiten zu verkürzen sowie gezielt bestimmte Probenstellen oder Probenbereiche in definiertem Umfang kontrolliert dünnen zu können.

Diese Aufgabe wird gemäß der Erfindung durch eine Ionenätzeinrichtung gemäß Anspruch 1 und durch ein Verfahren gemäß Anspruch 10 gelöst.

Im Rahmen der vorliegenden Erfindung wurde überraschenderweise festgestellt, daß die außerordentlich schwierigen, durch das hohe Magnetfeld und die engen Platzverhältnisse der Objektivlinse bedingten Anforderungen bei Transmissionselektronenmikroskopen dadurch gelöst werden können, daß der Einfluß des Magnetfelds der eingeschalteten Objektivlinse auf den Ionenstrahl dadurch kompensiert wird, daß der Ionenstrahl durch dezentrale mechanische Anordnung des Ionenstrahlers, also durch einen schrägen Einschuß des Ionenstrahls, oder durch spezielle Ablenkplatten, die einen schrägen Einschuß bzw. eine Auslenkung bewirken, den Probenort unter dem Einfluß des Magnetfelds nicht geradlinig, sondern in einer ionenoptischen Kurvenbahn erreicht, ohne daß zur Ionendünnung unter gleichzeitiger transmissionselektronenmikroskopischer Beobachtung, wie bisher für erforderlich gehalten wurde, die Objektivlinse ausgeschaltet werden muß. Der Ionenstrahl wird erfindungsgemäß also gerade so ausgelenkt oder um die Kurve gelenkt, daß er durch den Einfluß des zur Objektivebene senkrecht stehenden Magnetfeldes wieder auf die Probe gelenkt wird.

Mit der Erfindung werden Ziele erreicht, um die die Fachwelt sich schon lange bemüht hat. Mit der Erfindung ist es erstmals möglich, unter hochauflösenden Bedingungen, d.h. bei Vergrößerungsfaktoren größer als 10.000 bis ca. 1.000.000, entsprechend lateralen Auflösungen von 1,5 nm bis etwa 0,15 nm, eine Probenstelle oder einen Probenbereich "in situ" lokal zu dünnen und auf diese Weise gewünschte Probenstellen und Probendicken herauszupräparieren, ohne daß die Probe in eine externe Ätzeinrichtung bzw. in die Zwischenbildebene des Transmissionselektronenmikroskops gebracht werden muß oder eine lange Einlaufphase zur Erreichung eines stabilen Betriebs der Objektivlinse erforderlich ist. Durch die gezielte Ionendünnung werden ferner durch die Präparation bedingte Verschmutzungsprobleme des Transmissionselektronenmikroskopes reduziert.

Nach einem weiteren vorteilhaften Merkmal wird vorgeschlagen, daß mittels der Ionenlinse ein Ionenfokus am Probenort einstellbar ist. Der Ionenfokus hat vorteilhafterweise einen Durchmesser zwischen 0,5 und 100 µm, bevorzugt zwischen 0,5 und 20 µm, besonders bevorzugt zwischen 1 und 10 µm. Er entspricht damit den lateralen Abmessungen einer beobachteten Objektstelle, so daß eine lokale statt einer flächenhaften Ionendünnung durchgeführt wird. Die Ablagerungen auf der Objektivlinse und in anderen Bereichen des Transmissionselektronenmikroskops sowie die daraus resultierenden Verschmutzungsprobleme sind damit erheblich reduziert.

Nach dem Stand der Technik ist ein Ionenfokus einer unter optimalen Bedingungen betriebenen Ionenquelle von etwa 0,1 µm Durchmesser erreichbar. Dies ist jedoch unter den schwierigen Bedingungen, die durch die Abmessungen und das Magnetfeld einer Objektivlinse bedingt sind, bei der Transmissionselektronenmikroskopie nach dem derzeitigen Stand der Technik nicht möglich. Zur Erzielung eines möglichst kleinen Strahldurchmessers am Probenort ist es jedoch aus ionenoptischen Gründen vorteilhaft, einen möglichst kleinen Arbeitsabstand des Ionenstrahlers zum Probenort einzuhalten, vorzugsweise weniger als 5 cm, da die Abbildungsfehler der Ionenlinse mit zunehmender Brennweite ansteigen.

Nach einem anderen vorteilhaften Merkmal wird vorgeschlagen, daß die Ionenenergie kleiner als 5 keV, bevorzugt kleiner als 3 keV ist, um die Strahlenschäden in der Probe zu reduzieren. Die Fokussierung ist dann zwar problematischer als bei hohen Ionenenergien; es hat sich aber herausgestellt, daß im Rahmen der Erfindung auch niedrige Ionenenergien realisiert werden können. Die Ionenquelle kann beispielsweise eine Gasionenquelle mit Kaltionisierung, zum Beispiel als Sattelfeldionenquelle, oder mit Elektronenstoßionisierung, zum Beispiel als Heißkathoden-Ionenquelle, ausgeführt sein, die mit Edelgasen (zum Beispiel Ar oder He) oder mit reaktiven Gasen (zum Beispiel O₂, N₂ oder Freon) betrieben wird. Als besonders vorteilhaft haben sich zur Erzielung eines möglichst kleinen Strahldurchmessers am Probenort Ionenquellen herausgestellt, die als Gas-Feldionenquelle (He, H₂) oder als Flüssigmetall-Feldionenquelle (zum Beispiel Ga oder In) ausgeführt sind, da diese eine geringe Energie- und Richtungsunschärfe aufweisen.

Durch die erfindungsgemäße ionenoptische Kurvenbahn des Ionenstrahls im durchlaufenen magnetischen Sektorfeld der eingeschalteten Objektivlinse werden die Ionen auf die gewünschte Probenstelle gelenkt. Durch die Berücksichtigung der Ablenkung der Ionen im Magnetfeld und die Einstellung einer entsprechenden Einschußrichtung, beispielsweise durch eine schräge Anordnung des Ionenstrahlers oder mittels eines gekrümmten (zum Beispiel Zylinderkondensator) elektrostatischen Ablenkplattenpaares, ist es in den meisten Fällen möglich, eine hinreichende Fokussierung des Ionenstrahls auf die Probenstelle auch bei eingeschalteter Objektivlinse, insbesondere bei Verwendung von Flüssigmetall-Ionenquellen, zu erzielen. Eine geringe, durch die Energie- und Richtungsunschärfe der Ionenquelle bedingte, in vielen Fällen tolerierbare Auffächerung und Defokussierung des Ionenstrahls kann, auch bei einem homogenen Magnetfeld, jedoch dabei nicht ganz verhindert werden.

Zur weiteren Verbesserung der Fokussierung wird daher nach einem bevorzugten Merkmal vorgeschlagen, daß Ablenkplatten eines elektrostatischen Zylinderkondensator-Sektorfeldes vorgesehen sind, das derart ausgebildet ist, daß es in Kombination mit dem von den Ionen durchlaufenen magnetischen Sektorfeld der Objektivlinse eine Doppelfokussierung der Ionen bezüglich Energie und Anfangsrichtung bewirkt. Durch das Zylinderkondensator-Sektorfeld kann die Energie- und Richtungsdispersion der Ionen im Magnetfeld kompensiert werden, wodurch eine schärfere Fokussierung möglich ist.

Die doppelte Fokussierung bezüglich der Energie und Anfangsrichtung von Ionen ist bei Massenspektrometern bekannt. Zu Details wird auf die diesbezügliche Literatur, beispielsweise A. Benninghoven et al., Secondary Ion Mass Spectrometry, John Wiley & Sons (1987), Kapitel 4.1.9 verwiesen. Die doppelte Fokussieurng liefert eine Bündelung der ins Magnetfeld eintretende Ionen in parallelen Ebenen. Es wird also nicht nur eine Richtungsfokussierung erzielt, sondern auch eine Geschwindigkeitsfokussierung. Teilchen gleicher Massen, deren Geschwindigkeiten oder Richtungen etwas voneinander abweichen, werden annähernd in einem Punkt bzw. einer Linie vereinigt. Die Linien lassen sich, auch im Rahmen der Erfindung bei Transmissionselektronenmikroskopen, durch zusätzliche elektronenoptische Komponenten, beispielsweise Stigmatoren, auf einen Punkt fokussieren.

Mit der Erfindung lassen sich transmissionelektronenmikroskopische Proben unter hochauflösender Beobachtung direkt im Transmissionselektronenmikroskop "in situ" lokal ionendünnen. Damit können Zielpräparationen kontrolliert durchgeführt werden und Kontaminations- und Reaktionsschichten direkt im Mikroskopvakuum entfernt werden.

Die folgenden Ausführungsbeispiele der Erfindung lassen weitere vorteilhafte Merkmale und Besonderheiten erkennen, die anhand der schematischen Darstellung in den Zeichnungen im folgenden näher beschrieben und erläutert werden.

Es zeigen
- Fig. 1: ein Transmissionselektronenmikroskop nach der Erfindung,
- Fig. 2: eine Einzelheit zu Fig. 1,
- Fig. 3: eine Prinzipskizze eines Ionenstrahlverlaufs bei ausgeschalteter Objektivlinse,
- Fig. 4: ein erster erfindungsgemäßer Verlauf eines Ionenstrahls bei eingeschalteter Objektivlinse,
- Fig. 5: ein zweiter erfindungsgemäßer Verlauf eines Ionenstrahls bei eingeschalteter Objektivlinse,
- Fig. 6: ein dritter erfindungsgemäßer Verlauf eines Ionenstrahls bei eingeschalteter Objektivlinse,
- Fig. 7: eine doppelte Fokussierung nach Mattauch und Herzog,
- Fig. 8: einen Schnitt durch das Polschuhsystem einer Kondensor-Einfeldobjektivlinse mit Magnetfeldverlauf und Probe und
- Fig. 9: eine Skizze zur Anordnung der Probe im Probenraum.

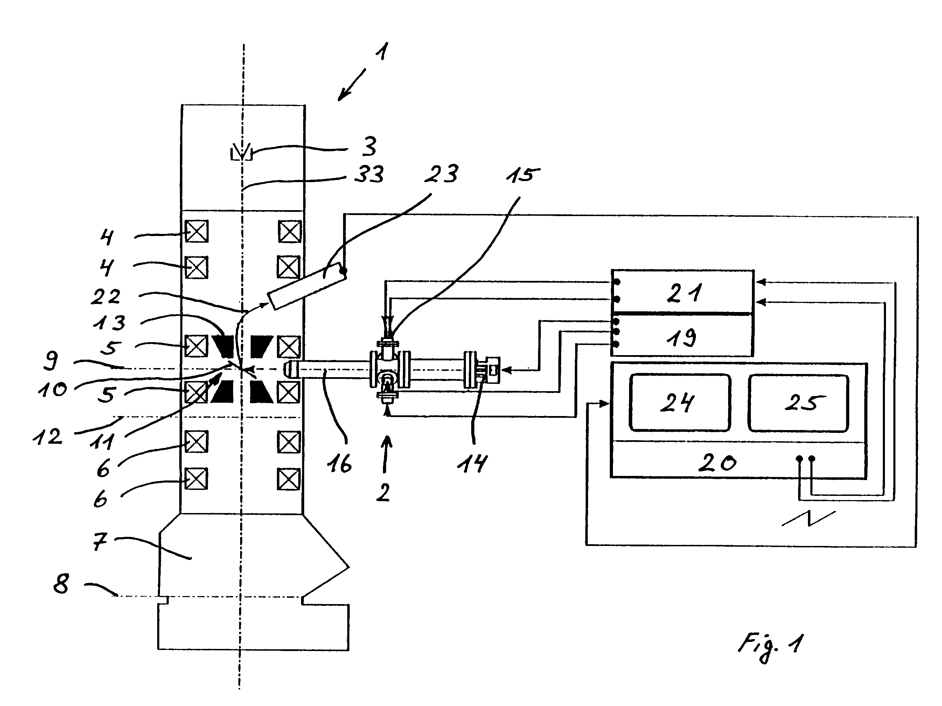

Die Fig. 1 zeigt ein Transmissionselektronenmikroskop 1 mit einer erfindungsgemäßen Ionenätzeinrichtung einschließlich elektronischer Ansteuerung des Ionenstrahlers 2. Die elektronenoptische Säule eines Transmissionselektronenmikroskops 1 besteht typischerweise aus dem Elektronenstrahlerzeuger 3, den Kondensorlinsen 4, der Objektivlinse 5, den Projektivlinsen 6 und dem Beobachtungsraum 7 mit einem Leuchtschirm in der Beobachtungsebene 8. Der Elektronenstrahlerzeuger 3 erzeugt Elektronen mit einer Energie von mehr als 100 keV, in der Regel um 200 keV. Weiter sind in Fig. 1 noch die Objektivebene 9, in der sich die Probe 10 im Probenraum 11 befindet, und die Zwischenbildebene 12, in der sich das Elektronenbild der Objektivlinse 5 befindet, eingezeichnet. Die Probe 10 befindet sich während der Abbildung in der Objektivebene 9 zwischen den Polschuhen 13 der Objektivlinse 5.

Der Ionenstrahler 2 umfaßt eine Ionenquelle 14 und eine Ionenlinse 15 zur Erzeugung eines Ionenstrahls 16. Er ist in der Objektivebene 9 auf gleicher Ebene wie die Probe 10 während der Abbildung angeordnet. Der Ionenstrahler ist mit einem speziellen Vakuumflansch mit dem Vakuum in der Mikroskopsäule so verbunden, daß über eine im Ionenstrahler 2 eingebaute Blende 17 eine Druckstufe zum Vakuumraum in der Objektivlinse 5 am Probenort gebildet wird. Der Vakuumraum im Ionenstrahler 2 zwischen der Blende 17 und einer weiteren Blende 18 kann über eine vom Objektiv- bzw. Probenraum 11 des Transmissionselektronenmikroskops 1 unabhängige zweite Pumpe evakuiert werden. Durch dieses differentielle Pumpsystem wird eine Beeinflussung des Probenraums 10 durch das Vakuum des Ionenstrahlers 2 und umgekehrt verhindert.

Die elektrische Ansteuerung des Ionenstrahlers 2 umfaßt eine Spannungsversorgung 19 für die Ionenquelle 14 und für die Ionenlinse 15, einen Scangenerator 20 und einen Ablenkverstärker 21. Mit dem Scangenerator 20 kann der Ionenstrahl 16 über die Probe 10 gerastert werden. Mit den dabei auf der Probe 10 ausgelösten Sekundärelektronen 22 (der Pfeil veranschaulicht die Bahn der Sekundärelektronen 22) kann mittels des Sekundärelektronendetektors 23 ein Rasterionenbild auf dem Rasterionenbild-Monitor 24 angezeigt werden. Auf dem Rasterelektronenbild-Monitor 25 kann gleichzeitig das mit dem Elektronenstrahl des Transmissionselektronenmikroskops 1 erzeugte Rasterelektronenbild in Reflexion oder Transmission beobachtet werden. Auf diese Weise ist eine einfache Justierung des Ionenstrahls 16 auf eine bestimmte Probenstelle 26 oder einen Probenbereich der Probe 10, an der mittels des Ionenstrahls 16 eine Ionendünnung durchgeführt werden soll, möglich. Die Probenstelle 26 kann gleichzeitig zu der Ionendünnung mit dem Transmissionselektronenmikroskop 1 in der Beobachtungsebene 8 beobachtet werden.

Der Ionenstrahl 16 kann mittels Ansteuerablenkplatten rasterförmig über die Probenoberfläche geführt werden. Das Transmissionselektronenmikroskop 1 kann vorteilhaft ein Raster-Transmissionselektronenmikroskop sein, wobei vorteilhafterweise die Ablenkung des Ionenstrahls 16 mittels der Rastereinheit des Raster-Transmissionselektronenmikroskops steuerbar ist und das Sekundärelektronenbild mittels des Sekundärelektronendetektors 23 des Raster-Transmissionselektronenmikroskops aufnehmbar ist.

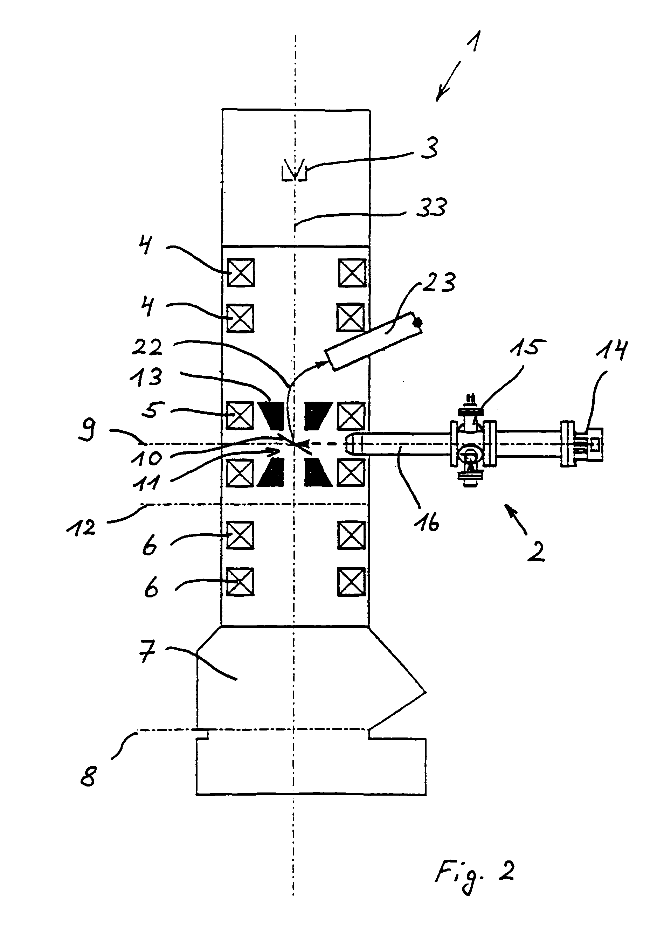

Die Fig. 2 zeigt das Transmissionselektronenmikroskop 1 der Fig. 1 mit dem Ionenstrahler 2 ohne die elektronische Ansteuerung. Nicht dargestellt ist eine gegebenenfalls vorhandene, im Bereich der Projektivlinsen 6 angeordnete, langbrennweitige Minilinse, mittels der bei ausgeschalteter Objektivlinse 5 eine Vergrößerung von ca. 10.000 erzielbar ist. Man erkennt die engen Platzverhältnisse im Bereich der Polschuhe 13 der Objektivlinse 5, welche die Halterung der Probe 10, den Einschuß des Ionenstrahls 16 und die Detektion der Sekundärelektronen 22 mittels eines Sekundärelektronendetektors 23 erschweren und ein Verschieben der Probe 10 in die Zwischenbildebene 12 im Innern des Transmissionselektronenmikroskops 1 unmöglich machen.

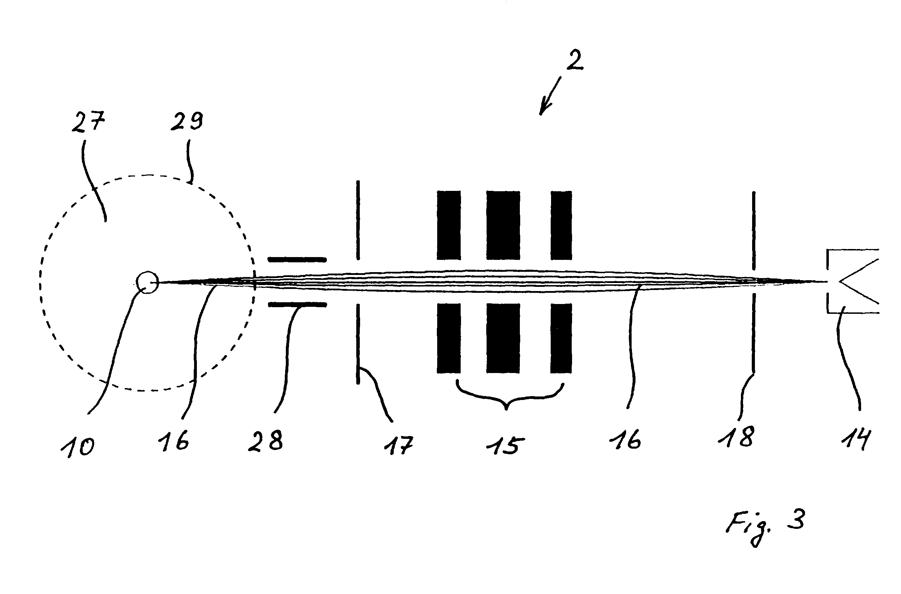

Die Fig. 3 zeigt den Verlauf des Ionenstrahls 16 bei ausgeschaltetem Magnetfeld 27 der Objektivlinse 5. Die Ionenlinse 15 dient zur Fokussierung des Ionenstrahls 16 auf die Probe 10. Die Blenden 17, 18 bilden eine Druckstufe, mittels der der Vakuumraum des Ionenstrahlers 2 von dem Probenraum 11 getrennt ist. Mit den Ablenkplatten 28 kann der Ionenstrahl 16 in der Objektivebene 9 und senkrecht dazu über die Probe 10 gerastert werden und auf eine bestimmte, interessante Probenstelle 26 gelenkt werden. Dabei sind nur kleine Vergrößerungen bei geringer Auflösung durch Vergrößerung mittels der Projektivlinse 6 oder einer anderen Hilfslinse möglich.

Bei eingeschaltetem Magnetfeld 27 der Objektivlinse 5 wird der Ionenstrahl 16 ab dem Polschuhrand 29 der Objektivlinse 5 auch von dem starken Magnetfeld 27 der Objektivlinse 5 abgelenkt und trifft nicht mehr auf die Probe 10. Dies kann durch achsenparallele Ablenkplatten 28 nicht kompensiert werden. Ein Ionenätzen ist daher bei den dargestellten, bekannten Anordnungen nur dann möglich, wenn die Objektivlinse 5 abgeschaltet ist. Wenn bei größeren Auflösungen und Vergrößerungen die Probe 10 beobachtet werden soll, muß zwischen Ionenätzen und transmissionselektronenmikroskopischer Beobachtung hin und her geschaltet werden, wobei die obengenannten Nachteile hinsichtlich der Reaktion der Probe 10 und der erforderlichen Experimentierzeit in Kauf genommen werden müssen.

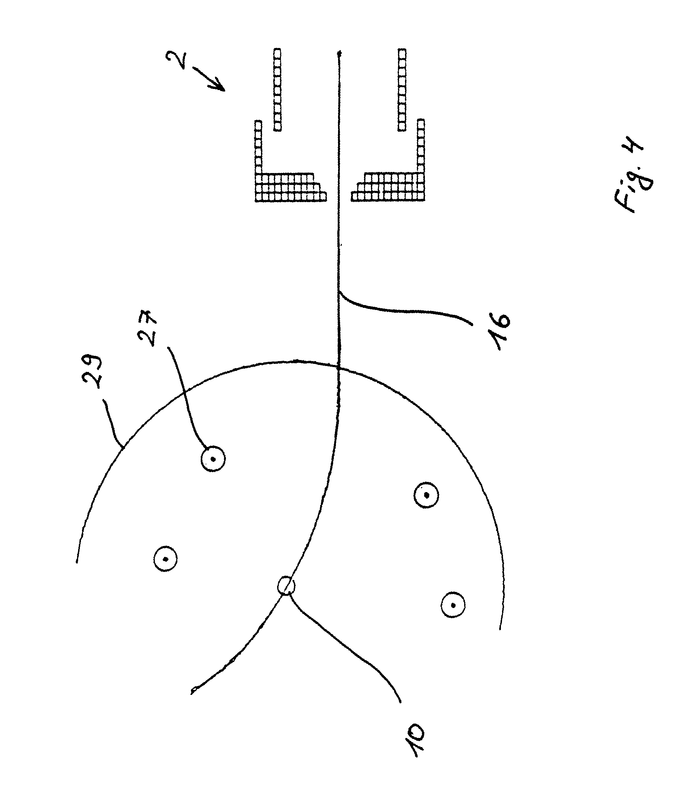

Die Fig. 4 zeigt eine erste erfindungsgemäße Ausbildung, bei der die Eintrittsrichtung des Ionenstrahls 16 in das von Ionen durchlaufene Magnetfeld 27 derart gewählt ist, daß es die Ionen auf eine Kurvenbahn lenkt, die bei eingeschalteter Objektivlinse 5 auf die Probe 10 und insbesondere eine gewünschte Probenstelle 26 führt. Der Ionenstrahler 2 ist einem schematischen Ausschnitt dargestellt. Der Ionenstrahl 16 wird nicht radial in das Magnetfeld 27, sondern unter einem bestimmten Eintrittswinkel eingeschossen. Hierzu ist der Ionenstrahler 2 zur Seite versetzt bzw. gedreht.

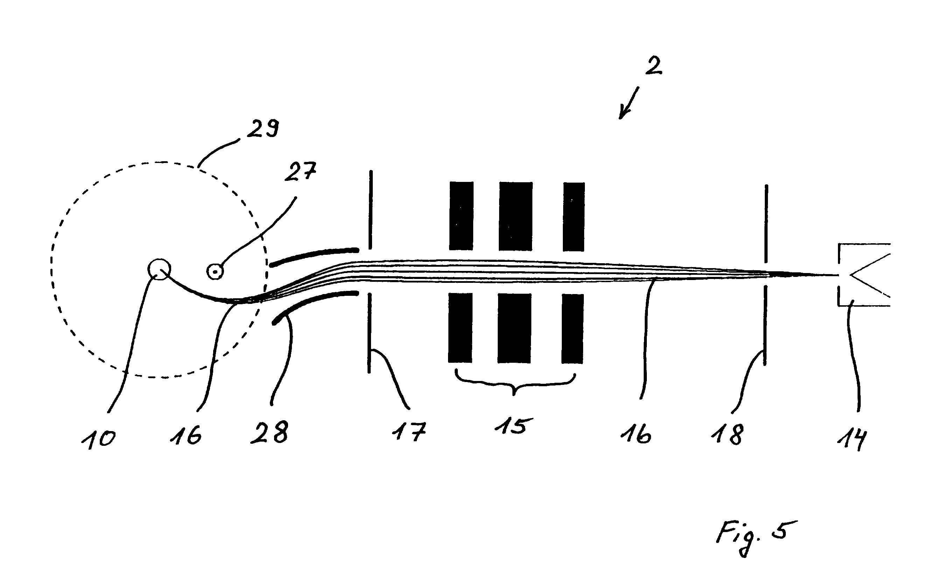

Die Fig. 5 zeigt eine alternative Ausbildung zu Fig. 4, in der der Ionenstrahl 16 zwar ursprünglich radial auf die Probe 10 gerichtet ist, vor dem Eintritt in das Magnetfeld 27 jedoch mittels eines elektrostatischen Ablenkplattenpaares mit gekrümmten Ablenkplatten 28 derart ausgelenkt wird, daß die Ionen in einer Kurvenbahn auf die Probe 10 treffen. Das Versetzen des Ionenstrahlers 2 gemäß Fig. 4 kann auch mit der elektrostatischen Auslenkung gemäß Fig. 5 kombiniert werden.

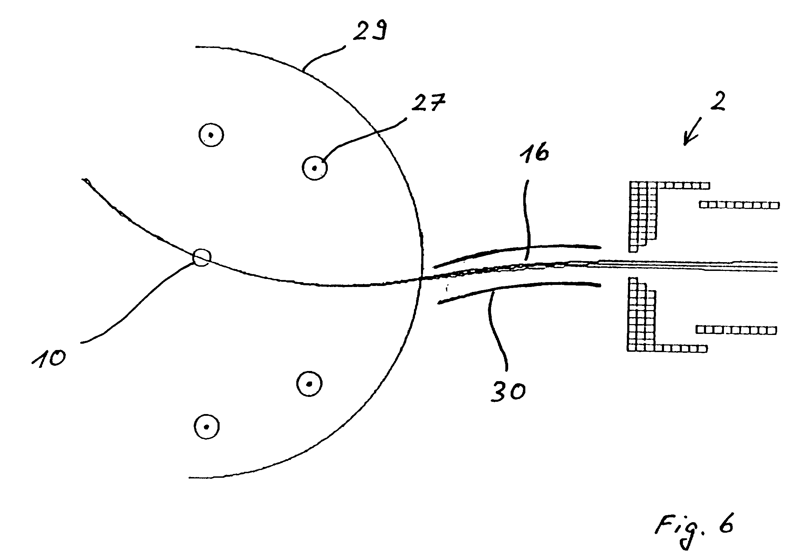

Wenn der Ionenstrahl 16 hinsichtlich seiner Energie und Richtung eine hinreichende Schärfe aufweist, ist es mit den Anordnungen gemäß Fig. 4 und 5 möglich, einen befriedigenden Fokus auf der Probe 10 zu erzeugen. Mit zunehmender Energie- oder Richtungsunschärfe des Ionenstrahls 16 wird jedoch die Energie- bzw. Richtungsdispersion im Magnetfeld 27 zu einer Auffächerung des Ionenstrahls 16 an der Probenstelle 26 führen. In diesem Fall ist eine Doppelfokussierung, wie sie in Fig. 6 dargestellt ist, vorteilhaft, um die Energie- und Richtungsdispersion zu kompensieren. Die ionenoptische Geometrie und die Feldstärke des elektrischen Zylinderkondensator-Sektorfelds 30 sind dabei so ausgeführt, daß sich zusammen mit der Geometrie und der Feldstärke des magnetischen Sektorfelds 27 der Objektivlinse 5 eine Doppelfokussierungsbedingung für die Probe 10 ergibt (siehe auch A. Benninghoven et al., Secondary Ion Mass Spectrometry, John Wiley & Sons (1987)).

Der ursprüngliche Ionenstrahl 16 kann dabei radial oder nicht radial auf die Probe 10 orientiert sein. Die Ablenkplatten 28 sind als Segment eines Zylinderkondensators 30 ausgebildet. Dadurch wird der Ionenstrahl 16 nicht nur so auf eine Kurvenbahn gelenkt, daß er durch den Einfluß des Magnetfelds 27 auf die Probe 10 gelenkt wird, sondern durch die Doppelfokussierung des Zylinderkondensators 30 in Kombination mit dem Magnetfeld 27 wird die Energie- und Richtungsdispersion des Ionenstrahls 16 kompensiert, so daß ein schärferer Fokus auf der Probe 10 entsteht.

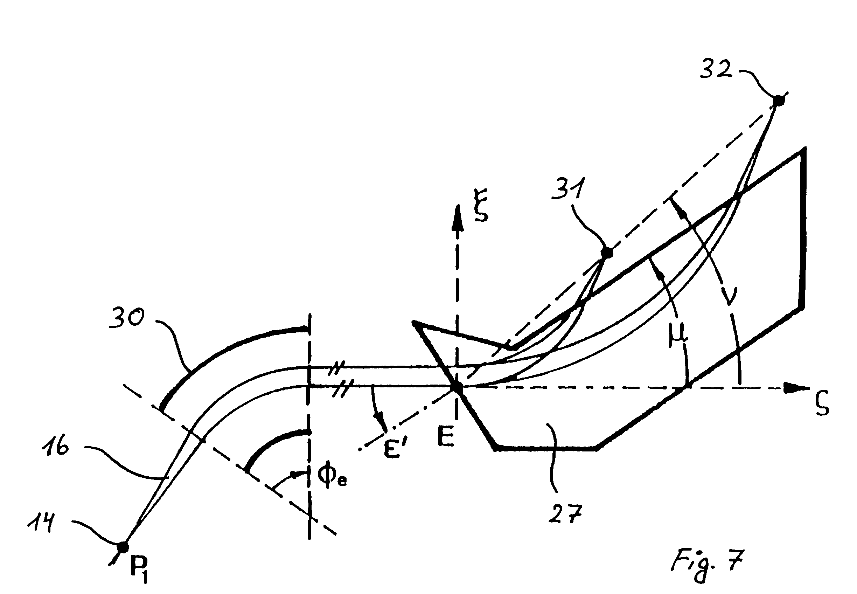

Die Fig. 7 zeigt einen vorteilhaften Spezialfall der Doppelfokussierung, der in der Literatur (siehe zum Beispiel Benninghoven et al.) zu Massenspektrometern als Anordnung nach Mattauch und Herzog bezeichnet wird. Es handelt sich dabei um eine spezielle Anordnung, bei der der Sektorwinkel des Zylinderkondensators 30 31,8° und der Ein- und Austrittswinkel des Ionenstrahls 16 im Zylinderkondensator 90° beträgt. Dargestellt ist die Ionenbahn für zwei unterschiedliche Ionenmassen, die jeweils mit einer Energie- und Richtungsunschärfe von einem Punkt P1 starten. Man erkennt, daß trotz ihrer Energie- und Richtungsunschärfe die Ionen der ersten Masse in einem ersten Fokus 31 und die Ionen der zweiten Masse in einem zweiten Fokus 32 fokussiert werden. Im erfindungsgemäßen Zusammenhang werden natürlich nicht Isotope mit verschiedenen Massen oder zumindest weitgehend isotopenreine Ionenquellen 14 verwendet, so daß die bei Massenspektrometern gewünschte Massendispersion in zwei verschiedene Fokusse 31, 32 nicht von Bedeutung ist, aber die Kompensation der Energie- und Richtungsunschärfe in vorteilhafter Weise genutzt werden. Für andere als die dargestellte Konfiguration eines gegebenen Magnetfeldes 27 mit einem speziellen elektrostatischen Feld eines Zylinderkondensators 30 läßt sich, wie in der Literatur gezeigt ist, immer ein Zylinderkondensator 30 in der Weise finden, daß in Kombination mit dem Magnetfeld 27 eine Doppelfokussierung erzielt wird.

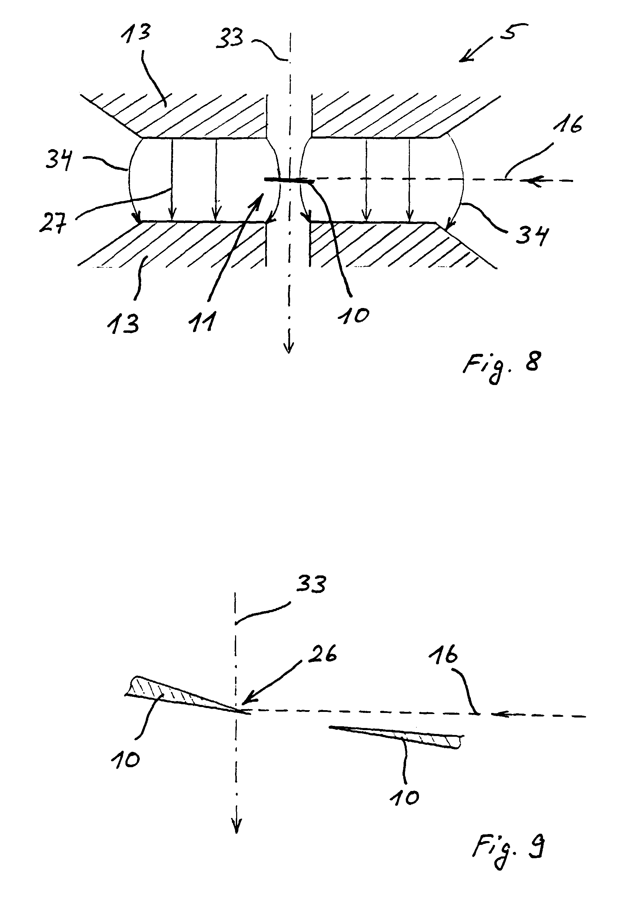

Die Fig. 8 zeigt eine schematische Prinzipskizze eines Schnitts durch die Objektivlinse 5 bzw. deren Polschuhe 13 eines Transmissionselektronenmikroskops 1. Es handelt sich dabei um eine Kondensor-Einfeldlinse, wie sie nach dem Stand der Technik zur Erzielung einer hohen Auflösung eingesetzt wird. Eine große Vergrößerung kann mittels geeigneter Projektivlinsen 6 erreicht werden, für eine hohe Auflösung ist jedoch ein möglichst starkes Magnetfeld von mehr als 0,5 T, vorzugsweise mindestens 1 bis 2 T am Ort der Probe 10 erforderlich. Eine Kondensor-Einfeldobjektivlinse ist eine Linse, bei der die Probe 10 zwischen zwei Polschuhen 13 angeordnet ist. Eine Kondensor-Einfeldlinse ist also gleichzeitig Kondensor- und Abbildungslinse.

Um ein hohes Magnetfeld 27 am Ort der Probe 10 erzielen zu können, ist der Probenraum 11 sehr beengt. Die Durchtrittsöffnung für den Elektronenstrahl 33 hat je nach Ausführung und Auflösung des Transmissionselektronenmikroskops 1 einen typischen Durchmesser von 0,5 bis 1 cm und der Abstand der Polschuhe 13 in Richtung des Elektronenstrahls 33 beträgt ca. 0,5 bis 1 cm. Der Ionenstrahl 16 verläuft vorteilhafterweise im Bereich der Objektivlinse 5 in der Proben- bzw. Objektebene 9 der Objektivlinse 5.

In Fig. 9 ist schematisch die Anordnung der Probe 10 bei der Bestrahlung mittels des Elektronenstrahls 33 und des Ionenstrahls 16 dargestellt. Sie wird von einem nicht dargestellten Probenhalter mit vorzugsweiser goniometrischer Aufhängung gehalten, der so ausgebildet ist, daß die Probenoberfläche unter gleichzeitiger Ionendünnung und transmissionselektronenmikroskopischer Beobachtung unter einem Winkel von -10° bis +10° gegen den Ionenstrahl 16 neigbar ist. Üblicherweise weist die Probe 10 durch die vorausgehende Behandlung ein Loch von ca. 100 bis 200 µm Durchmesser auf. Der Rand des Lochs ist keilförmig ausgebildet und stellt den nutzbaren Probenbereich dar. In dem Rand kann durch streifenden Einfall des Ionenstrahls 16 eine Nachbehandlung der Probe 10 an einer gewünschten lokalen Probenstelle 26 auf eine gewünschte Probendicke durchgeführt werden, wobei die Probenstelle 26 bei der Ionendünnung gleichzeitig hochauflösend mit dem Elektronenstrahl 33 beobachtet werden kann.

### Bezugszeichenliste

- 1: Transmissionselektronenmikroskop
- 2: Ionenstrahler
- 3: Elektronenstrahlerzeuger
- 4: Kondensorlinsen
- 5: Objektivlinse
- 6: Projektivlinse
- 7: Beobachtungsraum
- 8: Beobachtungsebene
- 9: Objektivebene
- 10: Probe
- 11: Probenraum
- 12: Zwischenbildebene
- 13: Polschuhe
- 14: Ionenquelle
- 15: Ionenlinse
- 16: Ionenstrahl
- 17: Blende
- 18: weitere Blende
- 19: Spannungsversorgung
- 20: Scangenerator
- 21: Ablenkverstärker
- 22: Sekundärelektronen
- 23: Sekundärelektronendetektor
- 24: Rasterionenbild-Monitor
- 25: Rasterelektronenbild-Monitor
- 26: Probenstelle
- 27: Magnetfeld
- 28: Ablenkplatten
- 29: Polschuhrand
- 30: Zylinderkondensator
- 31: Fokus
- 32: Fokus
- 33: Elektronenstrahl
- 34: Vorfeld

## Patentansprüche

1. Ionenätzeinrichtung zur Ionendünnung einer Probe (10) im Probenraum (11) eines Transmissionselektronenmikroskops (1) mit einer Objektivlinse (5), umfassend eine Ionenquelle (14) zur Erzeugung eines Ionenstrahls (16) und eine Ionenlinse (15), einen Sekundärelektronendetektor (23) zur Erzeugung eines Ionenraster-Sekundärelektronenbildes der Probenoberfläche mit Hilfe der bei gerasteter Ionenbestrahlung ausgelösten Sekundärelektronen (22) und zur Positionierung des Ionenstrahls (16) mittels des Ionenraster-Sekundärelektronenbildes auf eine bestimmte Probenstelle (26), wobei bei eingeschalteter Objektivlinse (5) die Probenstelle (26) gleichzeitig mit dem Ionenraster-Sekundärelektronenbild und mit dem Elektronenstrahl (33) des Transmissionselektronenmikroskops (1) in Transmission beobachtbar ist,
**dadurch gekennzeichnet**, daß
die Ionenenergie kleiner als 5 keV ist und der Ionenstrahl (16) im Bereich der Objektivlinse (5) in der Objektivebene (9) der Objektivlinse (5) verläuft und unter Berücksichtigung der Ablenkung der Ionen im Magnetfeld der Objektivlinse (5) der Einschuß des Ionenstrahls (16) in das von den Ionen durchlaufene magnetische Sektorfeld (27) der Objektivlinse (5) derart gewählt ist, daß zur Kompensation des Einflusses des Magnetfelds der Objektivlinse (5) das von den Ionen durchlaufene magnetische Sektorfeld (27) die Ionen gezielt auf einer Kurvenbahn auf die Probe (10) lenkt.

2. Ionenätzeinrichtung nach Anspruch 1, **dadurch gekennzeichnet**, daß mittels der Ionenlinse (15) ein Ionenfokus (31) am Probenort einstellbar ist und der Ionenfokus (31) am Probenort einen Durchmesser zwischen 0,5 und 100 µm, bevorzugt zwischen 0,5 und 20 µm und besonders bevorzugt zwischen 1 und 10 µm aufweist.

3. Ionenätzeinrichtung nach Anspruch 1, **dadurch gekennzeichnet**, daß sie Ablenkplatten (28) eines elektrostatischen Zylinderkondensator-Sektorfeldes (30) aufweist, das derart ausgebildet ist, daß es in Kombination mit dem von den Ionen durchlaufenen magnetischen Sektorfeld (27) der Objektivlinse (5) eine Doppelfokussierung der Ionen bezüglich Energie und Anfangsrichtung bewirkt.

4. Transmissionselektronenmikroskop (1), **dadurch gekennzeichnet**, daß es eine Ionenätzeinrichtung nach einem oder mehreren der Ansprüche 1 bis 3 aufweist.

5. Transmissionselektronenmikroskop (1) nach Anspruch 4, **dadurch gekennzeichnet,** daß die Objektivlinse (5) eine Kondensor-Einfeldlinse ist.

6. Transmissionselektronenmikroskop (1) nach Anspruch 4, **dadurch gekennzeichnet**, daß das Magnetfeld (27) am Probenort größer als 0,5, bevorzugt größer als 1 T ist.

7. Transmissionselektronenmikroskop (1) nach Anspruch 4, **dadurch gekennzeichnet**, daß die Energie der Elektronen zur Erzeugung des Transmissionselektronenbildes größer als 100 keV ist.

8. Transmissionselektronenmikroskop (1) nach Anspruch 4, **dadurch gekennzeichnet**, daß es einen Probenhalter aufweist, mit dem die Probenoberfläche unter gleichzeitiger Ionendünnung und transmissionselektronenmikroskopischer Beobachtung unter einem Winkel von - 10° bis + 10° gegen den Ionenstrahl (16) neigbar ist.

9. Transmissionselektronenmikroskop (1) nach Anspruch 4, **dadurch gekennzeichnet**, daß es zur hochauflösenden Transmissionselektronenmikroskopie mit einer lateralen Auflösung von besser als 1,5 nm bei gleichzeitiger Ionendünnung ausgebildet ist.

10. Verfahren zum Ionendünnen einer Probe im Probenraum (11) eines Transmissionselektronenmikroskops (1) mit einer Objektivlinse (5), insbesondere mittels einer Ionenätzeinrichtung nach einem der Ansprüche 1 bis 3 oder in einem Transmissionselektronenmikroskop nach einem der Ansprüche 4 bis 9, unter Verwendung einer Ionenquelle (14) zur Erzeugung eines Ionenstrahls (16), einer Ionenlinse (15) und eines Sekundärelektronendetektors (23) zur Erzeugung eines Elektronenraster-Sekundärelektronenbildes der Probenoberfläche mit Hilfe der bei gerasteter Ionenbestrahlung ausgelösten Sekundärelektronen (22) und zur Positionierung des Elektronenstrahls (33) mittels des Ionenraster-Sekundärelektronenbildes auf eine bestimmte Probenstelle (26), wobei bei eingeschalteter Objektivlinse (5) die Probenstelle (26) gleichzeitig mit dem Ionenraster-Sekundärelektronenbild und in Transmission mit dem Elektronenstrahl (33) des Transmissionselektronenmikroskops (1) beobachtet wird, **dadurch gekennzeichnet**, daß der Ionenstrahl (16) im Bereich der Objektivlinse (5) in der Objektivebene (9) der Objektivlinse (5) verläuft und die Ionen des Ionenstrahls (16) mit einer Energie unter 5 keV in das magnetische Sektorfeld (27) der Objektivlinse (5) eintreten und unter Berücksichtigung der Ablenkung der Ionen im Magnetfeld der Objektivlinse (5) derart in das magnetische Sektorfeld (27) der Objektivlinse (5) eingeschossen werden, daß zur Kompensation des Einflusses des Magnetfelds der Objektivlinse (5) das von den Ionen durchlaufene magnetische Sektorfeld (27) die Ionen gezielt auf einer Kurvenbahn auf die Probe (10) lenkt.

11. Verfahren nach Anspruch 10, **dadurch gekennzeichnet**, daß mittels der Ionenlinse (15) ein Ionenfokus (31) am Probenort erzeugt wird.

12. Verfahren nach Anspruch 10, **dadurch gekennzeichnet**, daß die Ionen ein elektrostatisches Zylinderkondensator-Sektorfeld (30) durchlaufen, das derart ausgebildet ist, daß es in Kombination mit dem von den Ionen durchlaufenen magnetischen Sektorfeld (27) der Objektivlinse (5) eine Doppelfokussierung der Ionen bezüglich Energie und Anfangsrichtung bewirkt.

## Claims

1. Ion-etching device for ion thinning of a sample (10) in a sample region (11) of a transmission electron microscope (1) having an objective lens (5) and comprising an ion source (14) for the production of an ion beam (16) and an ion lens (15), a secondary electron detector (23) for the production of an ion scan secondary electron image of the sample surface with the assistance of secondary electrons (22) released by scanning ion irradiation and for positioning the ion beam (16), via the ion scan secondary electron image, onto a particular sample location (26) wherein, with the objective lens (5) switched-on, the sample location (26) can be observed simultaneously with the ion scan secondary electron image and with the electron beam (33) of the transmission electron microscope (1) in transmission,
characterized in that
the ion energy is less than 5 keV and in that the ion beam (16), in the vicinity of the objective lens (5), travels in the objective plane (9) of the objective lens (5) and in that by taking into consideration the deflection of the ions in the magnetic field of the objective lens (5) the introduction of the ion beam (16) into the magnetic sector field (27) of the objective lens (5) through which the ions pass is chosen in such a fashion that for the compensation of the influence of the magnetic field of the objective lens (5) the magnetic sector field (27) through which the ions pass deflects the ions along a curved path onto the sample (10) in a defined manner.

2. Ion-etching device according to claim 1, characterized in that an ion focus (31) can be adjusted at the sample location by means of the ion lens (15) and the ion focus (31) at the sample location has a diameter between 0.5 and 100 µm, preferentially between 0.5 and 20 µm and particularly preferentially between 1 and 10 µm.

3. Ion-etching device according to claim 1, characterized by deflection plates (28) of an electrostatic cylindrical capacitor sector field (30) configured, in combination with the magnetic sector field (27) of the objective lens (5) through which the ions pass, to effect a double focusing of the ions with regard to energy and initial direction.

4. Transmission electron microscope (1), characterized by an ion-etching device according to one or more of the claims 1 through 3.

5. Transmission electron microscope (1) of claim 4, characterized in that the objective lens (5) is a condenser single field lens.

6. Transmission electron microscope (1) according to claim 4, characterized in that the magnetic field (27) at the sample location is larger than 0.5 and preferentially larger than 1 T.

7. Transmission electron microscope (1) according to claim 4, characterized in that the energy of the electrons for production of the transmission electron image is greater than 100 keV.

8. Transmission electron microscope (1) of claim 4, characterized by a sample holder for holding the sample surface, during simultaneous ion thinning and transmission electron microscopic observation, at an angle of -10° to +10° relative to the ion beam (16).

9. Transmission electron microscope (1) according to claim 4, characterized in that it is adapted for high resolution transmission electron microscopy having a transverse resolution better than 1.5 nm during simultaneous ion thinning.

10. Method for ion thinning of a sample in a sample region (11) of a transmission electron microscope (1) having an objective lens (5), in particular using an ion-etching device according to any one of the claims 1 through 3 or in a transmission electron microscope according to any one of the claims 4 through 9, using an ion source (14) for the production of an ion beam (16), an ion lens (15) and a secondary electron detector (23) for the production of a scanning electron secondary electron image of the sample surface with the assistance of the secondary electrons (22) released during the scanned ion irradiation and for positioning the electron beam (33), via the ion scanned secondary electron image, onto a particular sample location (26) wherein, with the objective lens (5) switched-on, the sample location (26) is observed in transmission with the electron beam (33) of the transmission electron microscope (1) simultaneously with the ion scan secondary electron image, characterized in that the ion beam (16) travels, in the vicinity of the objective lens (5), in the objective plane (9) of the objective lens (5) and in that the ions of the ion beam (16) enter into the magnetic sector field (27) of the objective lens (5) with an energy of less than 5 keV and in that by taking into consideration the deflection of the ions in the magnetic field of the objective lens (5) the ions are introduced into the magnetic sector field (27) of the objective lens (5) in such a fashion that for the compensation of the influence of the magnetic field of the objective lens (5) the magnetic sector field (27) through which the ions pass deflects the ions along a curved path onto the sample (10) in a defined manner.

11. The method according to claim 10, characterized in that an ion focus (31) at the sample location is produced by the ion lens (15).

12. The method of claim 10, characterized in that the ions travel through an electrostatic cylindrical capacitor sector field (30) which is configured, in combination with the magnetic sector field (27) of the objective lens (5) through which the ions pass, to effect a double focusing of the ions with regard to energy and initial direction.

## Revendications

1. Dispositif de décapage ionique pour l'amincissement ionique d'un échantillon (10) dans le compartiment échantillon (11) d'un microscope électronique à transmission (1) avec une lentille d'objectif (5) et comportant un source d'ions (14) pour la génération d'un faisceau ionique (16) et une lentille ionique (15), un détecteur d'électrons secondaire (23) pour la production d'une image d'électrons secondaires de balayage ionique de la surface de l'échantillon à l'aide des électrons secondaires (22) dégagés lors de l'irradiation ionique balayée et pour le positionnement du faisceau ionique (16) au moyen de l'image d'électrons secondaires de balayage ionique sur un point déterminé (26) de l'échantillon, dispositif dans lequel, la lentille d'objectif (5) étant enclenchée, le point (26) de l'échantillon pouvant être observé simultanément à l'aide de l'image d'électrons secondaires de balayage ionique et du faisceau électronique (33) du microscope électronique à transmission (1) en transmission,
**caractérisé en ce que**
l'énergie ionique est inférieure à 5 keV, que le faisceau ionique (16), dans la zone de la lentille d'objectif (5), s'étend dans le plan de l'objectif (9) de la lentille d'objectif (5) et que, en tenant compte de la déflexion des ions dans le champ magnétique de la lentille d'objectif (5), l'injection du faisceau ionique (16) dans le champ sectoriel magnétique (27) de la lentille d'objectif (5) à travers le quel passent les ions, est choisie de sorte que, pour la compensation de l'influence du champ magnétique de la lentille d'objectif (5), le champ sectoriel magnétique (27) parcouru par les ions dirige les ions sur l'échantillon (10) suivant une trajectoire courbe.

2. Dispositif de décapage ionique selon la revendication 1, **caractérisé en ce** qu'un foyer ionique (31) peut être ajusté à l'emplacement de l'échantillon à l'aide de la lentille ionique (15) et que le foyer ionique (31) à l'emplacement de l'échantillon présente un diamètre compris entre 0,5 et 100 µm, de préférence entre 0,5 et 20 µm, et notamment entre 1 et 10 µm.

3. Dispositif de décapage ionique selon la revendication 1, **caractérisé en ce** qu'il présente des déflecteurs (28) d'un champ sectoriel électrostatique (30) de condensateur cylindrique qui est configuré de sorte que, en combinaison avec le champ sectoriel magnétique (27) de la lentille d'objectif (5) parcouru par les ions, il produit une focalisation double des ions en ce qui concerne l'énergie et la direction initiale.

4. Microscope électronique à transmission (1) **caractérisé en ce** qu'il comprend un dispositif de décapage ionique suivant une ou plusieurs des revendications 1 à 3.

5. Microscope électronique à transmission (1) selon la revendication 4 **caractérisé en ce** que la lentille d'objectif (5) est une lentille de condenseur monochamp.

6. Microscope électronique à transmission (1) selon la revendication 4 **caractérisé en ce** que le champ magnétique (27) à l'emplacement de l'échantillon est supérieur à 0,5, de préférence supérieur à 1 T.

7. Microscope électronique à transmission (1) selon la revendication 4 **caractérisé en ce** que l'énergie des électrons pour la production de l'image électronique de transmission est supérieure à 100 keV.

8. Microscope électronique à transmission (1) selon la revendication 4 **caractérisé en ce** qu'il comprend un support d'échantillon qui permet d'incliner la surface de l'échantillon, tout en assurant en même temps l'amincissement ionique et l'observation au microscope électronique à transmission, suivant un angle de - 10° jusqu'à + 10° par rapport au faisceau ionique (16).

9. Microscope électronique à transmission (1) selon la revendication 4 **caractérisé en ce** qu'il permet la microscopie électronique à transmission haute résolution avec une résolution latérale supérieure à 1,5 nm en présence de l'amincissement ionique.

10. Procédé pour l'amincissement ionique d'un échantillon dans le compartiment échantillon (11) d'un microscope électronique à transmission (1) avec une lentille d'objectif (5), en particulier à l'aide d'un dispositif de décapage ionique suivant l'une quelconque des revendications 1 à 3, ou dans un microscope électronique à transmission suivant l'une quelconque des revendications 4 à 9, en utilisant une source d'ions (14) pour la génération d'un faisceau ionique (16), une lentille ionique (15) et un détecteur d'électrons secondaires (23) pour la production d'une image d'électrons secondaires de balayage électronique de la surface de l'échantillon à l'aide des électrons secondaires (22) dégagés lors de l'irradiation ionique balayée et pour le positionnement du faisceau électronique (33) au moyen de l'image d'électrons secondaires de balayage ionique sur un point déterminé (26) de l'échantillon, procédé dans lequel, la lentille d'objectif (5) étant enclenchée, le point (26) de l'échantillon pouvant être observé simultanément à l'aide de l'image d'électrons secondaires de balayage ionique et en transmission à l'aide du faisceau électronique (33) du microscope électronique à transmission (1), **caractérisé en ce** que le faisceau ionique (16), dans la zone de la lentille d'objectif (5), s'étend dans le plan de l'objectif (9) de la lentille d'objectif (5) et que les ions du faisceau ionique (16) entrent dans le champ sectoriel magnétique (27) de la lentille d'objectif (5) avec une énergie inférieure à 5 keV et, en tenant compte de la déflexion des ions dans le champ magnétique de la lentille d'objectif (5), lesdits ions sont injectés dans le champ sectoriel magnétique (27) de la lentille d'objectif (5) de sorte que, pour la compensation de l'influence du champ magnétique de la lentille d'objectif (5), le champ sectoriel magnétique (27) parcouru par les ions dirige les ions sur l'échantillon (10) suivant une trajectoire courbe.

11. Procédé selon la revendication 10, **caractérisé en ce** qu'un foyer ionique (31) est produit à l'emplacement de l'échantillon à l'aide de la lentille ionique (15).

12. Procédé selon la revendication 10, **caractérisé en ce** que les ions passent à travers un champ sectoriel électrostatique (30) de condensateur cylindrique qui est configuré de sorte que, en combinaison avec le champ sectoriel magnétique (27) de la lentille d'objectif (5) parcouru par les ions, il produit une focalisation double des ions en ce qui concerne l'énergie et la direction initiale.
